# EUROPEAN PATENT APPLICATION

(11) **EP 2 378 576 A2**
(43) Date of publication of application: **19.10.2011**
(21) Application number: 11162147.0
(22) Date of filing: 13.04.2011
(51) Int. Cl.: H01L 33/50, H01L 33/46, H01L 33/44, H01L 33/56, H01L 25/075

(54) **Light emitting diode package, lighting apparatus having the same, and method for manufacturing light emitting diode package**

(30) Priority: 15.04.2010 KR 20100034693; 14.12.2010 KR 20100127774
(71) Applicant: Samsung LED Co., Ltd., Gyunggi-do (KR)
(72) Inventor: Kim, Kyu Sang, Seoul (KR); KIM, Jin Ha, Seoul (KR); Jeong, Jae Yoo, Gyunggi-do (KR); Park, Moo Youn, Gyunggi-do (KR); Jeon, Chung Bae, Gyunggi-do (KR)
(74) Representative: Grünecker, Kinkeldey, Stockmair & Schwanhäusser

(57) **Abstract**

A light emitting diode (LED) package, a lighting apparatus including the same, and a method for manufacturing an LED package are disclosed. The LED package includes: a package substrate; an LED chip mounted on the package substrate; and a wavelength conversion layer formed to cover at least a portion of an upper surface of the LED chip when a surface formed by the LED chip when viewed from above is defined as the upper surface of the LED chip, wherein the wavelength conversion layer is formed so as not to exceed the area of the upper surface of the LED chip and includes a flat surface parallel to the upper surface of the LED chip and curved surfaces connecting the corners of the upper surface of the LED chip.

## Description

### CROSS-REFERENCE TO RELATED APPLICATIONS

This application claims the priority of Korean Patent Applications Nos. 10-2010-0034693 filed on April 15, 2010 and 10-2010-0127774 filed on December 14, 2010, in the Korean Intellectual Property Office, the disclosure of which is incorporated herein by reference.

### BACKGROUND OF THE INVENTION

### Field of the Invention

The present invention relates to a light emitting diode package, a lighting apparatus having the same, and a method for manufacturing a light emitting diode package.

### Description of the Related Art

Recently, a light emitting diode (LED) has been applied to various devices in various fields such as a keypad, a backlight, a traffic light, a guiding light in the runaway of an airport, a lighting bulb, and the like. As LEDs have been applied to various devices in various fields, the importance of a technique for packaging LEDs has emerged.

In a related art LED package, first and second lead frames are disposed within a package main body, and an LED chip is mounted on the first lead frame. The first and second lead frames are electrically connected by wires. In this case, the package main body has a cup-like shape, and a resin part is formed within the cup in order to protect the LED chip, the wires, and the like. In the resin part, phosphors (or a fluorescent material) for converting the wavelength of light to allow white light to be emitted from the LED chip may be dispersed in the resin part.

However, in the related art, light emitted from the LED chip is reflected and diffused a plurality of times in the resin part so as to be made incident to the package main body, the first and second lead frames, and the like, losing energy by an amount equal to that of the absorption rate of each surface. Namely, when the amount of incident light is 1 and the reflectivity of each surface is R, a portion of the incident light is absorbed at the rate of (1-R) and dissipated (i.e., becomes extinct).

In addition, the resin part is charged in the entirety of the interior of the package main body having the cup-like shape and light is emitted from the entire surface of the resin part, increasing etendue of the LED package. Thus, the related art LED package cannot be applied to fields of application in which a light source having a low etendue is required, for example, a light source for a camera flash, a camera head lamp, a projector, or the like. Here, the etendue is a value obtained by multiplying a solid angle of radiated light to the area of a light source, which is increased as the area of the light source is increased.

In addition, in the related art, a color temperature deviation of light is generated on a light emission surface of the LED chip, so when a radiation pattern of emitted light is viewed through a lens, color blurs known as bull's eyes excessively appear.

### SUMMARY OF THE INVENTION

An aspect of the present invention provides a light emitting diode (LED) package which has an improved luminous efficiency, emits light having a uniform color temperature from a light emission surface of an LED chip, and has a reduced color temperature variation as compared to other products, a method for manufacturing the LED package, and a lighting apparatus having the LED package.

According to an aspect of the present invention, there is provided a light emitting diode (LED) package including: a package substrate; an LED chip mounted on the package substrate; and a wavelength conversion layer formed to cover at least a portion of an upper surface of the LED chip when a surface formed by the LED chip when viewed from above is defined as the upper surface of the LED chip, wherein the wavelength conversion layer is formed so as not to exceed the area of the upper surface of the LED chip and includes a flat surface parallel to the upper surface of the LED chip and curved surfaces connecting the corners of the upper surface of the LED chip.

The LED package may further include a light reflective layer formed on the package substrate to surround the sides of the LED chip.

The light reflective layer may be made of a material including TiO₂.

The LED package may further include a light distribution layer covering the wavelength conversion layer and the light reflective layer.

The light distribution layer may be made of a material including SiO₂.

The LED package may further include a dam formed on the package substrate to demarcate a cavity for accommodating the LED chip, the light reflective layer, and the light distribution layer therein.

The dam may be made of a material including a resin.

The LED package may further include a transparent cover layer covering the LED chip.

The package substrate may be made of a material including a ceramic.

The wavelength conversion layer may be made of a material including a transparent resin and phosphors.

The weight ratio of the phosphors to the transparent material may be 2:1 or greater.

The LED chip may include: a structure support layer made of a conductive material; and a light emission structure formed on one surface of the structure support layer and including a p type semiconductor layer, an active layer, and an n type semiconductor layer.

The light emission structure may be formed on a portion of one surface of the structure support layer, and the upper surface of the LED chip may include one surface of the light emission structure and the other remaining area of one surface of the structure support layer in which the light emission structure is not formed.

The LED chip may include: a growth substrate; and a light emission structure formed on one surface of the growth substrate and including an n type semiconductor layer, an active layer, and a p type semiconductor layer, wherein the active layer and the p type semiconductor layer may be formed on a portion of one surface of the n type semiconductor layer.

The upper surface of the LED chip may include one surface of the p type semiconductor layer and the other remaining area of one surface of the n type semiconductor layer in which the active layer and the p type semiconductor layer are not formed.

The upper surface of the LED chip may be the other surface of the growth substrate.

The LED package may further include an electrode pad formed on the upper surface of the LED chip, wherein the wavelength conversion layer may be formed to cover the electrode pad.

The LED package may further include: a wire electrically connecting the electrode pad to the package substrate.

The wavelength conversion layer may extend to a side surface of the LED chip.

A plurality of LED chips and a plurality of wavelength conversion layers may be formed, and the plurality of wavelength conversion layers may be formed on upper surfaces of the plurality of LED chips, respectively.

A lighting apparatus including the foregoing LED package may be provided.

A method for manufacturing an LED package, including: mounting an LED chip on a package substrate; and applying a mixture including a transparent resin, phosphors, and a solvent to an upper surface of the LED chip, wherein after the solvent is removed from the mixture in the process of applying the mixture, the wavelength conversion layer is formed so as not to exceed the area of the upper surface of the LED chip and includes a flat surface parallel to an upper surface of the LED chip and curved surfaces connecting the flat surface and the corners of the upper surface of the LED chip, when a surface formed by the LED chip when viewed from above is defined as the upper surface of the LED chip.

The solvent may be made of a volatile material.

The method may further include: heating the mixture applied to the upper surface of the LED chip to allow the solvent to be evaporated in the process of applying the mixture.

The applying of the mixture may be performed by using a dispenser.

The applying of the mixture may include: continuously applying the mixture to maintain a state in which the mixture is applied to be continued from the upper surface of the LED chip to the dispenser.

The applying of the mixture may be performed while moving the dispenser in a spiral or zigzag manner over an upper side of the LED chip.

The method may further include: forming a light reflective layer on the package substrate to surround the sides of the LED chip, after the applying of the mixture.

The light reflective layer may be made of a material including TiO₂.

The method may further include: forming a light distribution layer covering the wavelength conversion layer and the light reflective layer, after the forming of the light reflective layer.

The light distribution layer may be made of a material including SiO₂.

The method may further include: forming a dam on the package substrate to demarcate a cavity accommodating the LED chip, the light reflective layer, and the light distribution layer therein, before the forming of the light reflective layer.

The dam may be formed on edges of the package substrate, and the method may further include: removing the dam and the edges of the package substrate on which the dam was formed, after the forming of the light distribution layer.

The dam may be made of a material including a resin.

The forming of the dam may be performed by using a dispenser.

The method may further include: forming a transparent cover layer covering the LED chip, after the applying of the mixture.

The package substrate may be made of a material including a ceramic.

The weight ratio of the phosphors to the transparent resin may be 2:1 or greater.

The LED chip may include: a structure support layer made of a conductive material; and a light emission structure formed on one surface of the structure support layer and including a p type semiconductor layer, an active layer, and an n type semiconductor layer.

The light emission structure may be formed on a portion of one surface of the structure support layer, and the upper surface of the LED chip may include one surface of the light emission structure and the other remaining area of one surface of the structure support layer in which the light emission structure is not formed.

The LED chip may include: a growth substrate; and a light emission structure formed on one surface of the growth substrate and including an n type semiconductor layer, an active layer, and a p type semiconductor layer, wherein the active layer and the p type semiconductor layer may be formed on a portion of one surface of the n type semiconductor layer.

The upper surface of the LED chip may include one surface of the p type semiconductor layer and the other remaining area of one surface of the n type semiconductor layer in which the active layer and the p type semiconductor layer are not formed.

The upper surface of the LED chip may be the other surface of the growth substrate.

An electrode pad may be formed on the upper surface of the LED chip, and the applying of the mixture may be performed to cover the electrode pad.

The method may further include: electrically connecting the electrode pad to the package substrate by using a wire, between the mounting of the LED chip and the applying of the mixture.

In the applying of the mixture, the mixture may be applied to the upper surface and the side surface of the LED chip.

A plurality of LED chips may be formed, and in the applying of the mixture, the mixture may be applied to the upper surfaces of the plurality of LED chips, respectively.

### BRIEF DESCRIPTION OF THE DRAWINGS

The above and other aspects, features and other advantages of the present invention will be more clearly understood from the following detailed description taken in conjunction with the accompanying drawings, in which:

FIG. 1 is a sectional view of a light emitting diode (LED) package according to an exemplary embodiment of the present invention;

FIG. 2 is a schematic view of a wavelength conversion layer of the LED package according to an exemplary embodiment of the present invention;

FIG. 3 is a graph of color temperature characteristics of the LED package according to an exemplary embodiment of the present invention;

FIGS. 4 to 6 are sectional views showing LED chips of the LED package according to an exemplary embodiment of the present invention;

FIGS. 7 to 9 are sectional views of light emitting diode (LED) packages according to another exemplary embodiment of the present invention;

FIG. 10 is a sectional view of a light emitting diode (LED) package according to another exemplary embodiment of the present invention;

FIG. 11 is a plan view of the LED package illustrated in FIG. 10;

FIG. 12 is a graph showing light distribution patterns of the LED package illustrated in FIG. 10;

FIG. 13 is a graph of color scattering of the LED package illustrated in FIG. 10 and that of a product;

FIGS. 14 to 16 are sectional views showing examples of the LED package according to an exemplary embodiment of the present invention;

FIG. 17 is a schematic view showing the LED package according to an exemplary embodiment of the present invention;

FIG. 18 is a flow chart illustrating a process of a method for manufacturing an LED package according to an exemplary embodiment of the present invention;

FIGS. 19 to 21 are views showing a process of forming a wavelength conversion layer in the method for manufacturing an LED package according to an exemplary embodiment of the present invention;

FIGS. 22 to 28 are sectional views showing respective processes of the method for manufacturing an LED package according to an exemplary embodiment of the present invention; and

FIGS. 29 to 35 are plan views showing the respective processes of the method for manufacturing an LED package according to another exemplary embodiment of the present invention.

### DETAILED DESCRIPTION OF THE PREFERRED EMBODIMENT

Exemplary embodiments of the present invention will now be described in detail with reference to the accompanying drawings. The invention may, however, be embodied in many different forms and should not be construed as being limited to the embodiments set forth herein. Rather, these embodiments are provided so that this disclosure will be thorough and complete, and will fully convey the scope of the invention to those skilled in the art. In the drawings, the shapes and dimensions may be exaggerated for clarity, and the same reference numerals will be used throughout to designate the same or like components.

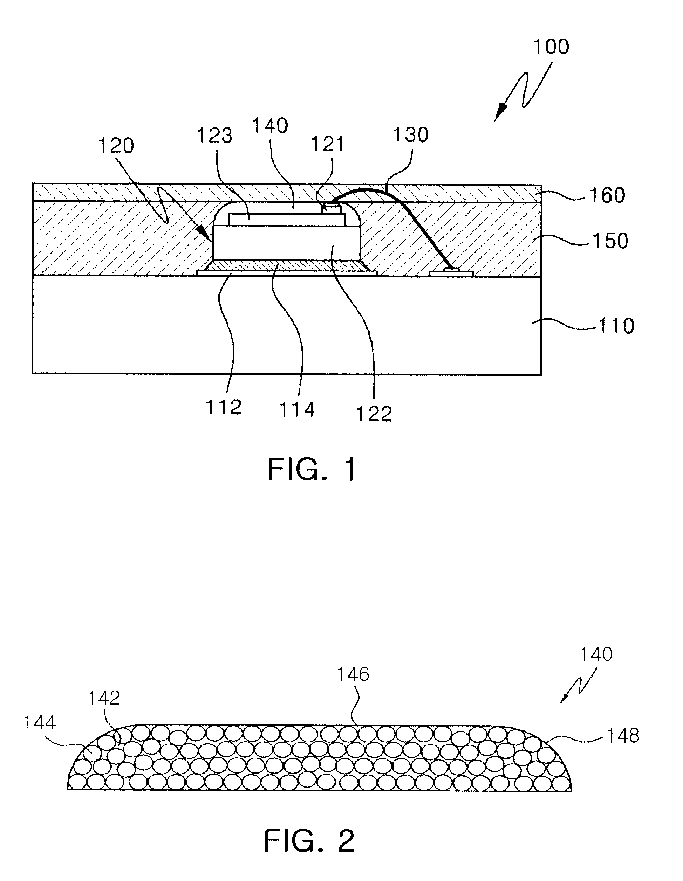

FIG. 1 is a sectional view of a light emitting diode (LED) package according to an exemplary embodiment of the present invention.

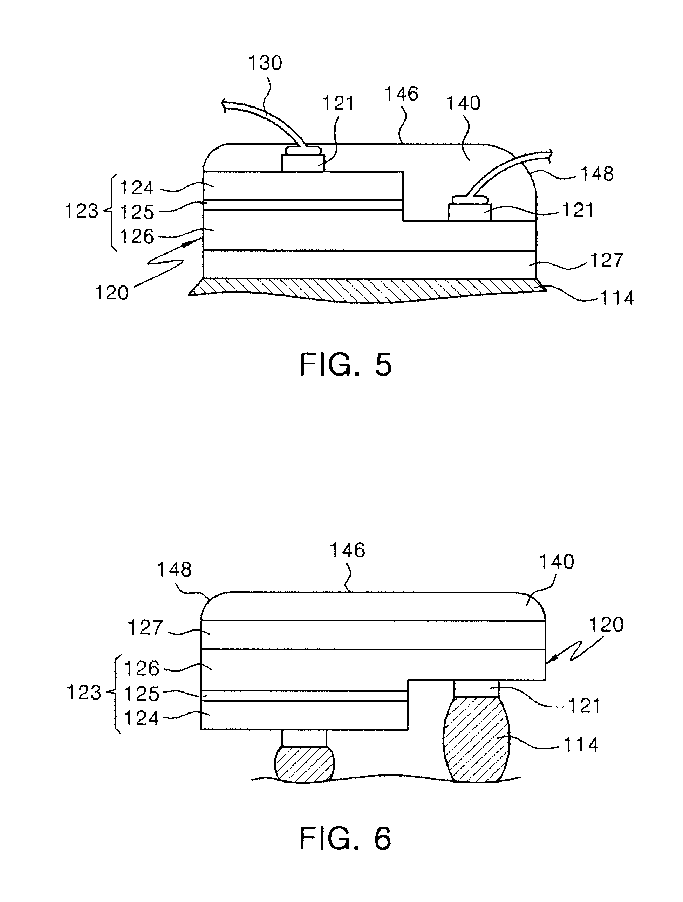

According to an exemplary embodiment of the present invention, as shown in FIG. 1, an LED package 100 including a package substrate 110, an LED chip 120 mounted on the package substrate 110 by means of an adhesive layer 114 and electrically connected to the package substrate 110 by a wire 130, a wavelength conversion layer 140 formed only on an upper surface of the element of the LED chip 120, a light reflective layer 150 charged to surround the LED chip 120, and a light distribution layer 160 covering the LED chip 120 and the light reflective layer 150. Here, the upper surface of the element of the LED chip 120 refers to a plane formed by the LED chip 120 when the LED chip 120 is viewed from above. In the aspect that the upper surface of the element of the LED chip 120 is formed when viewed from above, it may be formed to include areas each having a different height or being made of a different material. For example, with reference to FIG. 5, one upper surface of the LED chip 120 may be formed by a p type semiconductor layer 124 and an n type semiconductor layer 126 among a light emission structure 123. Terms such as 'upper surface', 'lower surface', and 'side surface' used in the present disclosure are based on the drawings attached hereto, which may differ to directions in which elements are disposed in actuality.

According to the present exemplary embodiment, unlike the related art LED package in which a resin part, including phosphors, is molded around the surroundings of an LED, as well as on the upper surface thereof, the wavelength conversion layer 140 is formed only on the upper surface of the LED chip 120, whereby a phenomenon in which a portion of generated light is absorbed by an ambient structure due to reflection and diffusion in the resin part can be minimized, improving the luminous efficiency of the LED package 100 and also reducing the overall light emission area thereof, thus increasing the possibility of the utilization thereof for various lighting apparatus in which a low etendue is required.

Also, the wavelength conversion layer 140 is formed on an upper surface of the LED chip 120 such that it has a flat surface 146 parallel to the upper surface, except for portions near the corners of the upper surface of the LED chip 120, whereby light generated from the LED chip 120 can have a uniform color temperature at the upper side of the LED chip 120, remarkably reducing color blurs (e.g., color stains or color specks) within the generated light.

Also, the wavelength conversion layer 140 can be formed to have an appropriate thickness in consideration of the characteristics of each of the LED chips 120 after the LED chips 120 are separated into individual LED chips 120, and thus the variation of color temperatures potentially generated among the respective LED package 100 products can be also effectively reduced.

The configuration of the LED package 100 according to the present exemplary embodiment of the present invention will now be described in detail with reference to FIGS. 1 to 6.

As shown in FIG. 1, a circuit pattern 1112 is formed on the package substrate 110, and the LED chip 120 is mounted on the circuit pattern 112, and an electrode pad 121 of the LED chip 120 may be electrically connected to the circuit pattern 112 through wire bonding.

Here, in order to improve the thermal dissipation properties and luminous efficiency thereof, the package substrate 110 may be made of a ceramic material, e.g., a material such as Al₂O₃, AlN, or the like, having a high heat resistance, excellent heat conductivity, a high reflection efficiency, and the like. However, the material of the package substrate 110 is not limited thereto, and various materials may be used to form the package substrate 110 in consideration of thermal dissipation properties, electrical connections, and the like, of the LED package 100.

Also, besides the foregoing ceramic substrate, a printed circuit board, a lead frame, and the like, may be also used as the package substrate 110 of the present exemplary embodiment.

As shown in FIG. 1, the LED chip 120 is mounted on the package substrate 110. Namely, the LED chip 120 is attached to the package substrate 110 by means of an adhesive layer 114, and the electrode pad 121 formed on the LED chip 120 may be electrically connected to the circuit pattern 112 of the package substrate 110 by the wire 130.

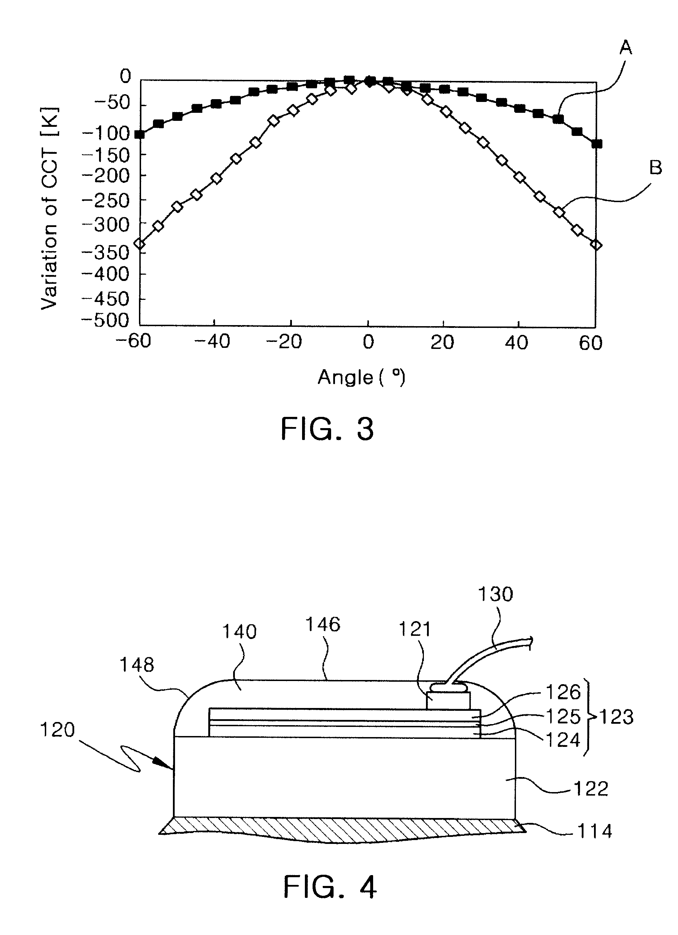

Here, the LED chip 120 may have various structures such as a vertical or horizontal structure, and the LED chip 120 may be electrically connected to the package substrate 110 in various manners such as wire bonding, flip-chip bonding, or the like. A specific structure of the LED chip 120 will be described in more detail later with reference to FIGS. 4 to 6.

The adhesive layer 114 may be made of a conductive material or a non-conductive material according to the structure of the foregoing LED chip 120, and the material of the adhesive layer 114 will be also described with reference to FIGS. 4 to 6.

FIG. 2 is a schematic view of the wavelength conversion layer 140 of the LED package 100 according to an exemplary embodiment of the present invention.

The wavelength conversion layer 140 may convert the wavelength of a portion of light generated from the LED chip 120, and as the wavelength-converted light is mixed with the other remaining light which has not been wavelength-converted, white light can be emitted from the LED package 100.

For example, when the LED chip 120 emits blue light, a wavelength conversion layer 140 containing yellow phosphors 144 may be used to generate white light, and when the LED chip 120 emits ultraviolet light, a wavelength conversion layer 140 in which red, green, blue phosphors 144 are mixed may be used to form white light. Besides, various types of LED chips 120 and various types of phosphors 144 may be variably combined to generate white light.

As shown in FIGS. 1 and 2, the wavelength conversion layer 140 is formed only on the upper surface of the LED chip 120, and the surface of the wavelength conversion layer 140 may include the flat surface 146 parallel to the upper surface and a curved surface 148 connecting the flat surface 146 and the corners of the upper surface.

Namely, as shown in FIGS. 1 and 2, the wavelength conversion layer 140 is formed so as not to exceed the area of the upper surface of the LED chip 120, and the wavelength conversion layer 140 is formed to have the flat surface 146 parallel to the upper surface of the LED chip 120 and is formed to have the curved surface 148 connecting the flat surface 146 and the corners of the upper surface of the LED chip 120 at the area adjacent to the corners of the upper surface of the LED chip 120.

Here, as discussed above, the upper surface of the LED chip 120 refers to a light emission surface provided as a path allowing light from the LED chip 120 to emit therethrough. According to the structure of the LED chip 120, the upper surface may be a single surface having the same height or may include a plurality of surfaces viewed as one surface from above although the plurality of surfaces may be stepped with relation to one another. The structure of the LED chip 120 will be described later with reference to FIGS. 4 to 6.

The flat surface 146 of the wavelength conversion layer 140 may refer to a case in which there is an unavoidable variation in height in terms of the process, rather than a case in which it is physically parallel to the upper surface of the LED chip 120. For example, the height of the flat surface 146 of the wavelength conversion layer 140 may vary within the range of about -10% to +10%, based on an average value thereof.

In addition, the width of a central region of the wavelength conversion layer 140 in which the flat surface 146 is formed may be a distance between two points corresponding to about 70% of the respective lengths from the center of the upper surface of the LED chip 120 to both corners of the upper surface thereof, based on the sectional view of FIG. 1, and the width of the flat surface 146 of the wavelength conversion layer 140 may vary depending on process conditions such as physical characteristics of a material, viscosity of a mixture, or a heating temperature of the mixture, for forming the wavelength conversion layer 140.

As shown in FIG. 2, the wavelength conversion layer 140 may be made of a material including a transparent resin 142 and phosphors 144, and the thickness of the wavelength conversion layer 140 formed on the central area of the upper surface of the LED chip 120 may be set to be within a range, for example, of 30 micrometers to 150 micrometers.

Light converted by the wavelength conversion layer 140 and light emitted from the LED chip 120 are mixed to allow for the emission of white light from the LED package 100. For example, when blue light is emitted from the LED chip 120, yellow phosphors may be used, and when ultraviolet light is emitted from the LED chip 120, red, green, and blue phosphors may be mixed to be used. Besides, the colors of the phosphors and the LED chip 120 may variably combined to emit white light. Also, only wavelength conversion materials such as green, red, and the like, may be applied to implement a light source for emitting corresponding colors, not necessarily white light.

In detail, when blue light is emitted from the LED chip 120, the red phosphor used therewith may include an MAlSiNx:Re (1≤x≤5) nitride phosphor, an MD:Re sulphide phosphor, and the like. Here, M is at least one selected from among Ba, Sr, Ca, and Mg, and D is at least one selected from among S, Se, and Te, while Re is at least one selected from among Eu, Y, La, Ce, Nd, Pm, Sm, Gd, Tb, Dy, Ho, Er, Tm, Yb, Lu, F, Cl, Br, and I. Also, the green phosphor used therewith may include an M₂SiO₄:Re silicate phosphor, an MA₂D₄:Re sulphide phosphor, a β-SiAlON:Re phosphor, and an MA'₂O₄:Re' oxide-based phosphor of, and the like. Here, M may be at least one selected from among Ba, Sr, Ca, and Mg, A may be at least one selected from among Ga, Al, and In, D may be at least one selected from among S, Se, and Te, A' may be at least one selected from among Sc, Y, Gd, La, Lu, Al, and In, Re may be at least one selected from among Eu, Y, La, Ce, Nd, Pm, Sm, Gd, Tb, Dy, Ho, Er, Tm, Yb, Lu, F, Cl, Br, and I, and Re' may be at least one selected from among Ce, Nd, Pm, Sm, Tb, Dy, Ho, Er, Tm, Yb, F, Cl, Br, and I.

The wavelength conversion layer 140 may include quantum dots in the place of the phosphors or provided with the phosphors. A quantum dot is a nano-crystal particle including a core and a shell, and the core size thereof ranges from 2 nm to 100 nm. The quantum dot may be used as phosphor emitting various colors such as blue (B), yellow (Y), green (G), and red (R), and at least two types of a semiconductor among a group II-VI compound semiconductor (ZnS, ZnSe, ZnTe, CdS, CdSe, CdTe, HgS, HgSe, HgTe, MgTe, etc.), a group III-V compound semiconductor (GaN, GaP, GaAs, GaSb, InN, InP, InAs, InSb, AlAs, AlP, AlSb, AlS, etc.), or a group IV semiconductor (Ge, Si, Pb, etc.) may be hetero-junctioned to form a core and shell structure constituting a quantum dot. In this case, in order to terminate molecular binding on a surface of the shell of the quantum dot at an outer edge of the shell, restrain the cohesion of the quantum dot and improve the dispersion characteristics of the resin such as the silicon resin, the epoxy resin, or the like, or improve the phosphor function, an organic ligand, using a material such as oleic acid, may be formed. The quantum dot is vulnerable to moisture or air, and in particular, when it is in contact with a plated pattern of the substrate, or the lead frame of the package, a chemical reaction may take place. Thus, the wavelength conversion layer 140 may be applied only to the upper surface of the LED chip 120, eliminating the possibility of contact with the plated pattern or the lead frame, to thus improve the reliability thereof. Thus, although the phosphors are taken as an example of the wavelength conversion material, the phosphors can be replaced with quantum dots or quantum dots may be added to the phosphors.

The weight ratio of the phosphors 144 to the transparent resin 142 may be 2:1 or greater. Thus, as shown in FIG. 2, the transparent resin 142 serves to bond the phosphor 144 particles, and the transparent resin 142 may be made of, for example, silicon, epoxy, or a material obtained by mixing silicon and epoxy.

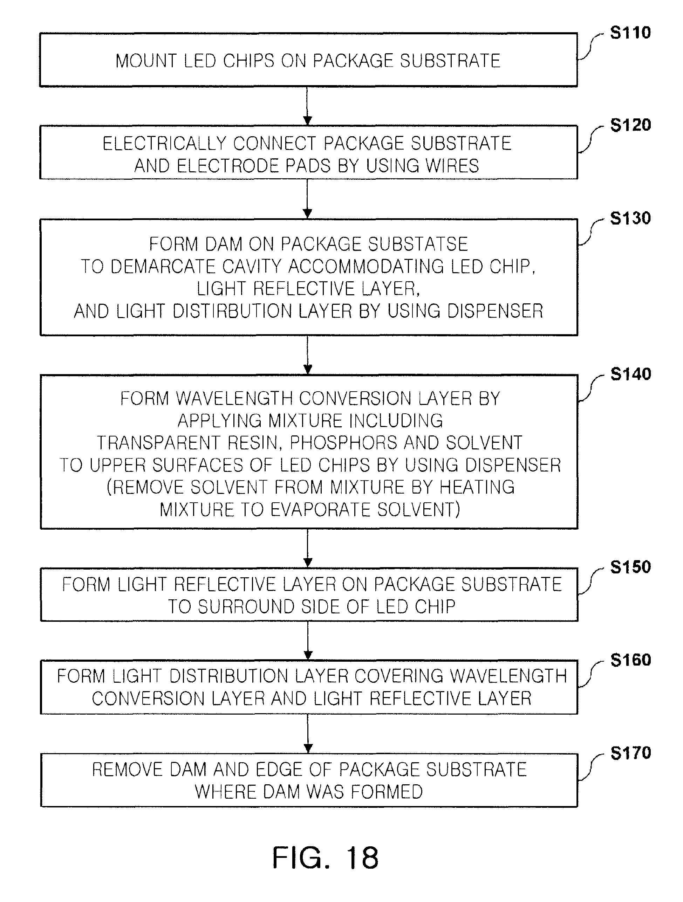

The rate of the phosphors 144 is remarkably high, when compared with that of the related art in which the rate of phosphors to a transparent resin is merely 1/10 or 1. Thus, with such a high rate, the mixture of the phosphors 144 and the transparent resin 142 may have increased viscosity, decreasing mobility on the upper surface of the LED chip 120. Thus, the wavelength conversion layer can be prevented from being formed to have an overall curved surface due to an influence of a surface tension otherwise caused by a low viscosity of the phosphors and transparent resin and can be formed to have a uniform thickness on the upper surface of the LED chip 120. This will be described in more detail later in explaining a method for manufacturing an LED package 200 with reference to FIGS. 18 to 35.

According to the present exemplary embodiment, because the wavelength conversion layer 140 is only formed on the upper surface of the LED chip 120, light absorption by a surrounding structure can be minimized to improve the luminous efficiency of the LED package 100, compared with LED packages of the related art in which the surroundings of the LED, as well as the upper surface of the LED, are entirely molded with phosphors, and in addition, because a package main body for molding the phosphors such as that of the related art is not required, the LED package 100 can be considerably reduced in size.

In addition, a substantial light emission area is confined to the upper surface of the LED chip 120, increasing the amount of light per area of a light source. Thus, the LED package 100 can be more positively utilized for various lighting apparatuses for which a low etendue is required.

Also, because the wavelength conversion layer 140 has the flat surface 146 parallel to the upper surface of the LED chip 120, the LED package 100 can emit light uniformly. Namely, the wavelength conversion layer 140 is formed to have a uniform thickness, excluding only the corner portions of the upper surface of the LED chip 120, to have a uniform optical path, whereby light generated from the LED chip 120 can have a uniform color temperature although its wavelength is changed while the light passes through the wavelength conversion layer 140.

FIG. 3 is a graph of color temperature characteristics of the LED package 100 according to an exemplary embodiment of the present invention. The foregoing effect will be described in detail with reference to FIG. 3.

FIG. 3 is a graph showing comparative color temperature characteristics (A) of the LED package 100 over radiation angles and color temperature characteristics (B) of the related art LED package, in which resin containing phosphors is molded on the entirety of the interior of the package main body, over radiation angles.

As shown in FIG. 3, in the case of the related art (B), variations of the color temperatures over the radiation angles are generated up to a maximum of 322K, causing severe color blurring. In comparison, in the case of the LED package 100 (A), according to the present exemplary embodiment, the variations of the color temperatures over the radiation angles are merely a maximum of 126K, less than half of that of the related art, resulting in a uniform light emission without color blurring.

Meanwhile, the wavelength conversion layer 140 may further include transparent fine particles along with the phosphors 144 and the transparent resin 142. The transparent fine particles may be made of a material such as SiO₂, TiO₂, Al₂O₃, or the like. In this manner, the color temperature of light emitted to the exterior can be set to have a desired level by appropriately regulating the rate of the transparent fine particles contained in the wavelength conversion layer 140, and in this case, for example, the weight ratio of the transparent fine particles to the phosphors 144 may be 1:2 or less.

As shown in FIG. 1, the light reflective layer 150 is formed on the package substrate 110 to surround the side of the LED chip 120. For example, the light reflective layer may be formed by charging a material including a reflecting material, such as TiO₂, or the like, which reflects incident light, around the LED chip 120 through a dispensing or molding operation.

In this case, as shown in FIG. 1, the light reflective layer 150 may be formed to have a height corresponding to the height of the wavelength conversion layer 140 formed on the upper surface of the LED chip 120, so the wavelength conversion layer 140 may not be covered by the light reflective layer 150.

Thus, because the light reflective layer 150 is formed to surround the LED chip 120, light reflected, rather than being emitted to the exterior, after being made incident to the light distribution layer 160, can be reflected toward the light distribution layer 160 again so as to be discharged to the exterior, resulting in an improvement to the luminance of the LED package 100.

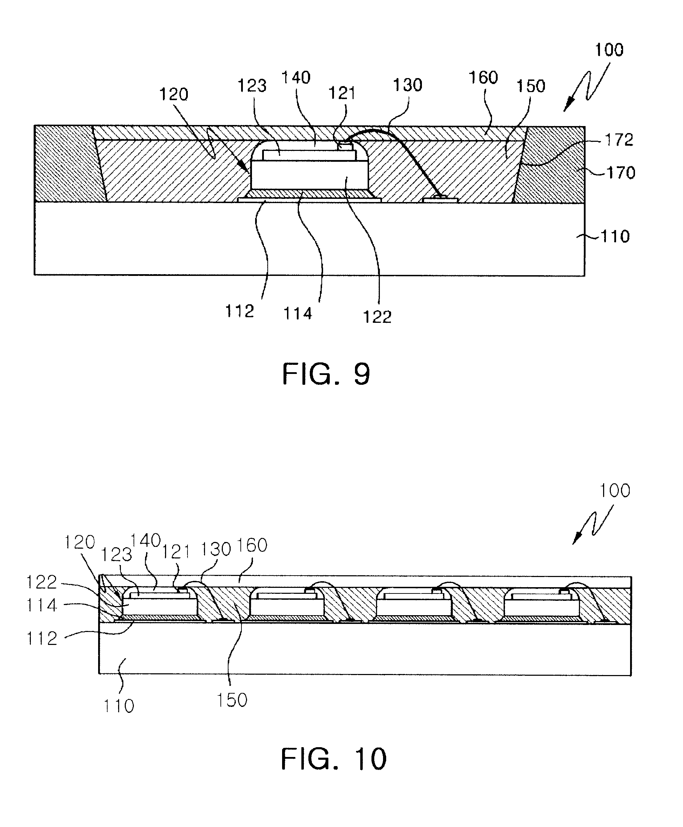

The light reflective layer 150 may be formed within a cavity 172 demarcated by a dam (170 in FIG 9) formed on the package substrate 110. The dam (170 in FIG. 9) may be removed in a process of dicing the LED package 100 into a unit LED package after the light reflective layer 150 and the light distribution layer (to be described) are formed.

The dam (170 in FIG. 9) may be made of a resin, a buffering material. Accordingly, although the package substrate 110 made of a ceramic material as described above is expanded or contracted according to heating and cooling operations in the manufacturing process, because the dam 170 can be deformed to correspond to the degree of expansion and contraction, a phenomenon in which the package substrate 110 is bent, or the like, can be effectively prevented and AlN having excellent thermal resistance may be used as a material of the package substrate 110.

The formation and removal of the dam 170 will be described again in more detail later in explaining a method for manufacturing an LED package 200 with reference to FIGS. 18 to 35.

As shown in FIG. 1, the light distribution layer 160 may be formed to cover the light reflective layer 150 and the wavelength conversion layer 140 not covered by the light reflective layer 150. The light distribution layer 160 may be formed by applying a material including a dispersing agent (or a dispersant), such as SiO₂, or the like, that disperses incident light, to the light reflective layer 150 and the wavelength conversion layer 140 through a dispensing operation.

The light reflective layer 150 may also be formed in the cavity 172 demarcated by the foregoing dam 170, and may be removed in the process of dicing the LED package 100 into a unit package.

Because the light distribution layer 160 is formed to cover the light reflective layer 150 and the wavelength conversion layer 140, light generated from the LED chip can be distributed to be emitted to the exterior, improving a light uniformity of the LED package 100.

Various structures of the LED chip 120 which can be applicable to the present exemplary embodiment will now be described with reference to FIGS. 4 to 6.

FIGS. 4 to 6 are sectional views showing LED chips of the LED package according to an exemplary embodiment of the present invention.

First, with reference to FIG. 4, an LED chip 120 having a vertical structure is proposed.

The LED chip 120 may include a structure support layer 122 and a light emission structure 123 formed on the structure support layer 122, and the light emission structure 123 may include a p type semiconductor layer 124, an active layer 125, and an n type semiconductor layer 126.

As shown in FIG. 4, the structure support layer 122 serves to structurally support the light emission structure 123 and because it is bonded to the circuit pattern (112 in FIG. 1) of the package substrate 110 by the conductive adhesive layer 114, it can also serve to implement an electrical connection between the package substrate 110 and the LED chip 120.

Thus, the structure support layer 122 is made of a conductive material selected from among Au, Ni, Al, Cu, W, Si, Se, GaAs or a combination of two or more of them, and the adhesive layer 114 is made of conductive solder, paste, or the like.

As shown in FIG. 4, the p type semiconductor layer 124, the active layer 125, and the n type semiconductor layer 126 of the light emission structure 123 are sequentially formed in this order on the structure support layer 122, and are made of a compound semiconductor such as GaAs, AlGaAs, GaN, InGaInP, or the like, to generate light.

As shown in FIG. 4, an electrode pad 121 serving as an n type electrode is formed on the n type semiconductor layer 126 and connected to the circuit pattern 112 of the package substrate 110 through the wire 130.

As shown in FIG. 4, the light emission structure 123 may be formed on an area excluding corner portions of one surface of the structure support layer 122. The light emission structure 123 having such a configuration may be obtained through an etching process for separating the LED chips 120 into individual unit LED chips.

In this case, the upper surface of the LED chip 120 may be defined by one surface of the light emission structure 123, namely, the upper surface of the n type semiconductor layer 126, and the area of the corner portions of one surface of the structure support layer 122 on which the light emission structure 123 is not formed.

Accordingly, as shown in FIG. 4, the wavelength conversion layer 140 may be formed on the upper surface of the n type semiconductor layer 126 and the corner areas of one surface of the structure support layer 122, both being the upper surface of the LED chip 120. As mentioned above, the central area is configured as the flat surface 146, and the corner areas are configured as the curved surfaces 148. Even in this case, the wavelength conversion layer 140 is formed so as not to exceed the corner portions of one surface of the structure support layer 122.

The wavelength conversion layer 140 is formed in a state in which the LED chip 120 is mounted and the electrode pad 121 and the circuit pattern 112 are wire-bonded, so, as shown in FIG. 4, a portion of the wire 130, namely, a bonding portion as a coupling portion with the electrode pad 121, as well as the electrode pad 121, is buried in the wavelength conversion layer 140.

Subsequently, as shown in FIG. 5, an LED chip 120 having a horizontal structure is proposed.

The LED chip 120 illustrated in FIG. 5 may include a growth substrate 127 and a light emission structure 123 formed on the growth substrate 127. The light emission structure 123 may include an n type semiconductor layer 126, an active layer 125, and a p type semiconductor layer 124.

A sapphire substrate, or the like, may be used as the growth substrate 127, and the light emission structure 123 including the n type semiconductor layer 126, the active layer 125, and the p type semiconductor layer 124 may be grown to be formed on the growth substrate 127. Because the growth substrate 127 is an insulating body, it can be physically bonded to the substrate 110 by the adhesive layer 114.

As shown in FIG. 5, the active layer 125 and the p type semiconductor layer 124 may be formed on a portion of one surface of the n type semiconductor layer 126. This structure can be formed by growing the active layer 125 and the p type semiconductor layer 124 on the n type semiconductor layer 126 and then mesa-etching portions of the active layer 125 and the p type semiconductor layer 124.

In FIG. 5, the step formed by mesa-etching the active layer 125 and the p type semiconductor layer 124 is shown to be exaggerated, but in actuality, the step is very small for the thickness of the growth substrate 127.

As shown in FIG. 5, the electrode pads 121 serving as an n type electrode and a p type electrode, respectively, are formed on the n type semiconductor layer 126 and the p type semiconductor layer 124. The electrode pads 121 may be electrically connected to the circuit pattern 112 of the package substrate 110 (in FIG. 1) by using wires 130, respectively.

As shown in FIG. 5, the upper surface of the LED chip 120 may be defined by an upper surface of the p type semiconductor layer 124 and the other remaining area of one surface of the n type semiconductor layer 126 without the active layer 126 and the p type semiconductor layer 124 as they have been mesa-etched out.

Accordingly, as shown in FIG. 5, the wavelength conversion layer 140 may be formed on the upper surface of the p semiconductor layer 124 and on the portion of the n type semiconductor layer 126 exposed by mesa-etching the active layer 125 and the p type semiconductor layer 124, the upper surface of the p semiconductor layer 124 and the portion of the n type semiconductor layer 126 being the upper surface of the LED chip 120. As mentioned above, the central area of the wavelength conversion layer 140 is formed as the flat surface 146 and the corner areas thereof are formed as the curved surfaces 148. Also, even in this case, the wavelength conversion layer 140 is formed so as not to exceed the corners of the n type semiconductor layer 126.

Like the LED chip 120 having the vertical structure, the wavelength conversion layer 140 is formed in a state in which the LED chip 120 is mounted and the electrode pad 121 and the circuit pattern 112 are wire-bonded, so, as shown in FIG. 4, the electrode pads 121 and portions of the wire 130 are buried in the wavelength conversion layer 140.

With reference to FIG. 6, an LED chip 120 mounted on the substrate 110 according to a flip-chip method is provided.

As shown in FIG. 6, the LED chip 120 may include a growth substrate 17 and a light emission structure 123 formed under the growth substrate 127. The light emission structure may include the n type semiconductor layer 126, the active layer 125, and the p type semiconductor layer 124 from top to bottom in this order.

The LED chip 120 illustrated in FIG. 6 has a similar basic structure to that of the LED chip 120 having the horizontal structure illustrated in FIG. 5, and in this case, the LED chip 120 is electrically connected to the package substrate 110 (in FIG. 1) according to a flip chip method, rather than the wire bonding.

Namely, as shown in FIG. 6, the electrode pads 121 formed on the n type semiconductor layer 126 and the p type semiconductor layer 124, respectively, are physically bonded to the circuit pattern 112 (in FIG. 1) of the package substrate 110 (in FIG. 1) by the conductive adhesive layer 114 such as a solder bump, or the like, so as to be electrically connected.

In this case, as shown in FIG. 6, the upper surface of the LED chip 120 may be defined as the upper surface of the growth substrate 127.

Thus, as shown in FIG. 6, the wavelength conversion layer 140 may be formed on the upper surface of the growth substrate 127, the upper surface of the LED chip 120, and as mentioned above, the central area of the wavelength conversion layer 140 is formed as the flat surface 146, and the corner areas thereof are formed as the curved surfaces 148. In this case, the wavelength conversion layer 140 is formed so as not to exceed the corners of the growth substrate 127.

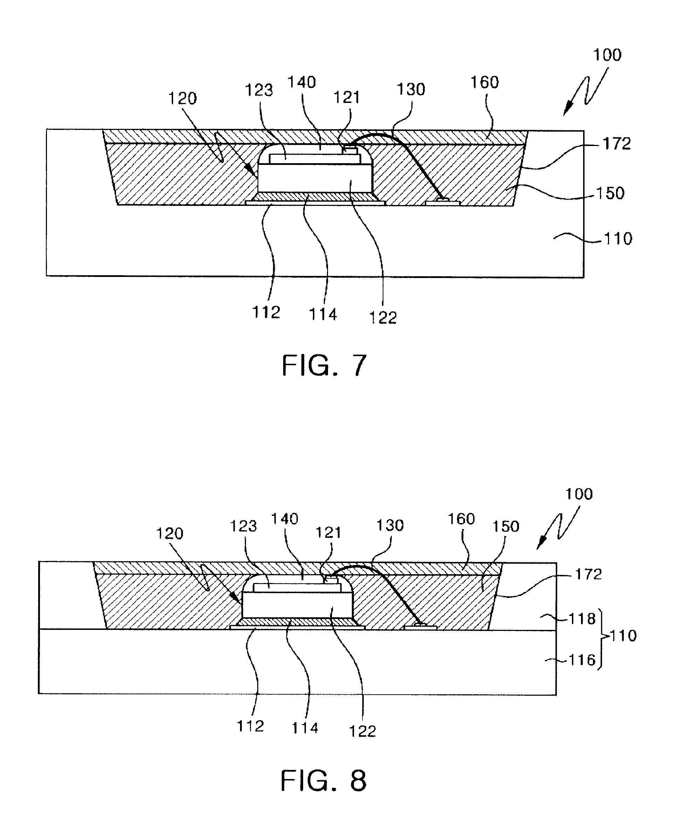

The LED package 100 according to another exemplary embodiment of the present invention will now be described with reference to FIGS. 7 to 9.

FIGS. 7 to 9 are sectional views of examples of the LED 100 package according to an exemplary embodiment of the present invention.

In describing the examples of the LED package 100 according to an exemplary embodiment of the present invention, a description of the same or similar configurations as those described above will be omitted and a different configuration will be described.

With reference to FIG. 7, the LED package 100 according to an exemplary embodiment of the present invention is configured such that the cavity 172 is formed on the package substrate 110, and the LED chip 120, the light reflective layer 150, and the light distribution layer 160 are accommodated in the cavity 172.

Referring to the LED package 100 illustrated in FIG. 1, the light reflective layer 150 and the light distribution layer 160 are formed in the cavity 172 demarcated by the dam 170 (in FIG. 9) and the dam 170 is removed through a dicing process of separating the LED package 100 into a unit package.

Comparatively, as shown in FIG. 7, the cavity 172 may be formed on the package substrate 110 itself to form the light reflective layer 150 and the light distribution layer 160 therein, and the cavity 172 remains in a final produce of the LED package 100.

With reference to FIG. 8, the LED package 100 according to an exemplary embodiment of the present invention is configured such that the package substrate 110 includes a first substrate 116 and a second substrate 118, and the cavity 172 is formed on the second substrate 118 to accommodate the LED chip 120, the light reflective layer 150, and the light distribution layer 160 therein.

Unlike the LED package 100 illustrated in FIG. 1, in the LED package 100 illustrated in FIG. 8, the second substrate 118 having the cavity 172 is stacked on the first substrate 116 to thus secure the space for mounting the LED chip 120 and forming the light reflective layer 150 and the light distribution layer 160.

The first and second substrates 116 and 118 may be made of a ceramic material, such as Al₂O₃, AlN, or the like, having characteristics such as a high thermal resistance, excellent heat conductivity, high reflection efficiency, and the like.

With reference to FIG. 9, the LED package 100 according to an exemplary embodiment of the present invention is configured such that the dam 170 demarcating the cavity 172 is formed on the package substrate 110, and the LED chip 120, the light reflective layer 150, and the light distribution layer 160 are accommodated in the cavity 172.

Like the LED package 100 illustrated in FIG. 1, in the LED package 100 according to the present exemplary embodiment, the dam 170 made of a resin is formed on the substrate to demarcate the cavity 172 to mount the LED chip 120 and form the light reflective layer 150 and the light distribution layer 160, but the LED package 100 illustrated in FIG. 9 is different from the LED package 100 illustrated in FIG. 1 in that the dam 170 remains in a final product.

As described above with reference to the LED package 100 illustrated in FIG. 1, the dam 170 may be made of a resin, a buffering material. Thus, although the package substrate 110 made of a ceramic material is expanded or contracted according to heating and cooling operations in the course of the manufacturing process of the LED package 100 or in the course of operating the LED package 100, because the dam 170 can be deformed to correspond to the degree of expansion and contraction, a phenomenon in which the package substrate 110 is bent, or the like, can be effectively prevented, and AlN, having merits in terms of thermal resistance, may be used as a material of the package substrate 110.

Meanwhile, the LED packages 100 illustrated in FIGS 7 to 9 employ the LED chip 120 having the vertical structure illustrated in FIG. 4, but the present invention is not limited thereto and the LED chips 120 illustrated in FIGS. 5 and 6 and an LED chip having any other substrate may be also applicable to the LED packages 100.

Other examples of the LED package 100 according to an exemplary embodiment of the present invention will now be described with reference to FIGS. 10 to 13.

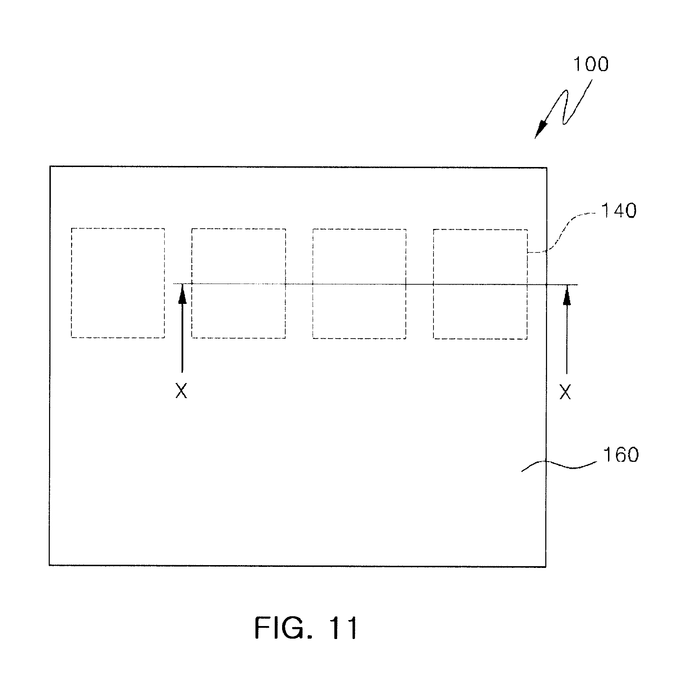

FIG. 10 is a sectional view of a light emitting diode (LED) package according to another exemplary embodiment of the present invention, and FIG. 11 is a plan view of the LED package illustrated in FIG. 10.

In describing the examples of the LED package 100 according to an exemplary embodiment of the present invention, a description of the same or similar configurations as those described above will be omitted and a different configuration will be described.

As shown in FIG. 10, a plurality of LED chips 120 are disposed to be spaced apart from one another and, accordingly, a plurality of wavelength conversion layers 140 are formed on the upper surfaces of the respective LED chips 120, unlike the LED chip 120 illustrated in FIG. 1.

In the present exemplary embodiment, as shown in FIG. 10, the light reflective layer 150 may be charged at the respective sides surrounding the LED chips 120 and in the space between the LED chips 120.

According to the present exemplary embodiment, the light reflective layer 150 is charged in the space between the LED chips 120, and the light distribution layer 160 is formed on the LED chip 120 and the light reflective layer 150, whereby the luminous intensity in the space between the LED chips 120 can be improved to results in obtaining an overall uniform luminous intensity distribution of thee LED package 100 in which the plurality of LED chips 120 are mounted.

Namely, in case of the related art LED package in which the resin part including phosphors is molded within the package main body a dark portion exists in the space between the LED chips, but in the present exemplary embodiment, as shown in FIG. 10, the wavelength conversion layer 140 is uniformly formed on the upper surface of the diode chip 120, and the light reflective layer 150 is formed in the space between the LED chips 120 and the light distribution layer 160 is formed on the wavelength conversion layer 140 and the light reflective layer 150, whereby the luminous intensity in the space between the LED chips 120 can be improved to form a uniform luminous intensity distribution.

In more detail, the light distribution layer 160 uniformly distributes light emitted from the LED chip 120, and the light reflective layer 150 reflects, which is reflected from the light distribution layer 160, toward the exterior again, so the luminous intensity in the space between the LED chips 120, which corresponds to a dark portion in related art LED package, can be remarkably improved.

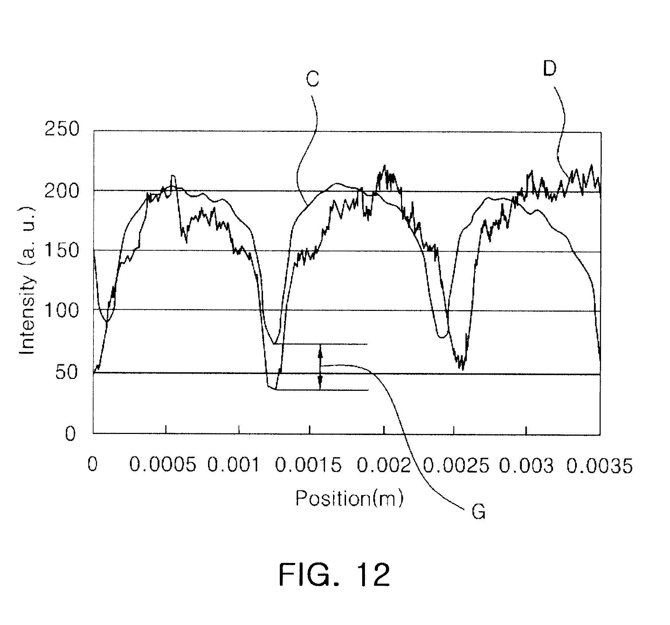

FIG. 12 is a graph showing a two-dimensional luminous intensity distribution of the LED package 100 taken along line X-X in FIG. 11. In FIG. 12, the luminous intensity distribution (C) of the LED package 100 according to the present exemplary embodiment and a luminous intensity distribution (D) of the related art LED package in which the resin including phosphors are molded on the entirety of the interior of the package main body are comparatively shown.

As shown in FIG. 12, the luminous intensity in the space between the LED chips 120 of the LED package (C), which corresponds to a dark area, is increased compared with the related art (D), and in detail, the difference (G) between the luminous intensities is about 45 a.u. or more. Thus, because the formation of the dark portion in the areas between the plurality of LED chips 120 of the LED package 100 according to the present exemplary embodiment is minimized, the overall luminous intensity of the LED package 100 can resultantly have a uniform distribution.

Also, according to the present exemplary embodiment, the wavelength conversion layer 140 can be formed to have an appropriate thickness in consideration of individual characteristics of the respective LED chip 120 separated into a unit chip, so the variation in the color temperature which may be generated among the respective LED package 100 products can be effectively reduced.

Namely, in a wafer level phosphor film formation method, namely, in the case of collectively forming a phosphor film before separating the LED chips 120 into unit chips, the phosphor film having the same thickness is applied without reflecting or considering the luminous characteristics of the respective chips, increasing the variation in the color temperature compared with the present invention. In the present exemplary embodiment, as described above, the wavelength conversion layer 140 can be formed to have a different thickness according to the characteristics of each chip, thus effectively reducing the variation in the color temperature among the respective LED package 100 products.

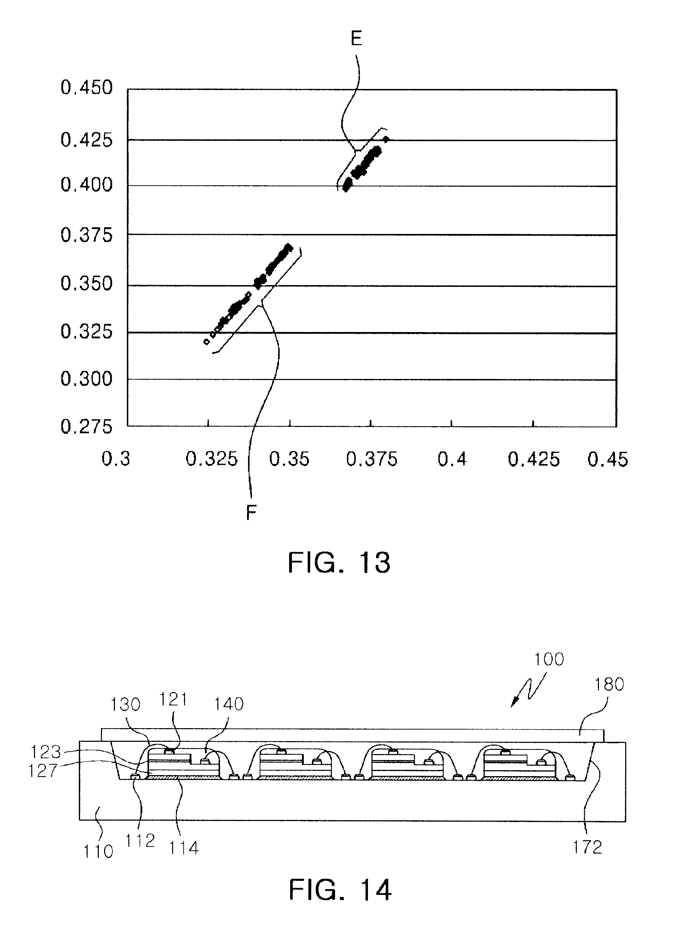

FIG. 13 is a graph of color scattering of the LED package 100 products illustrated in FIG. 10. The effect of reducing the variation in color temperature among the foregoing products will be described again.

Specifically, FIG. 13 is a graph of a CIE color coordinate system showing a color temperature distribution (E) among the LED package 100 products and a color temperature distribution (F) among the LED package products in which the resin part including phosphors is molded within the package main body according to the related art, when power of the mounted LED chip 120 ranges from 390 mW to 410 mW, the central wavelength has a distribution ranging from 445 nm to 450 nm, and the LED chip 120 is driven with a current of 750 mA.

As shown in FIG. 13, in the case (E) of the LED package 100 according to the present exemplary embodiment, the color scattering among the products is approximately 176K, which is equivalent to approximately less than 40 %. Thus, in the case of the LED package 100 according to the present exemplary embodiment, as described above, in the forming of the wavelength conversion layer, the thickness of the wavelength conversion layer 140 is precisely adjusted individually for each of the LED chips 120, so the color temperature variation among the respective LED package 100 products can be significantly reduced.

Other examples of the LED package 100 according to an exemplary embodiment of the present invention will now be described with reference to FIGS. 14 to 17.

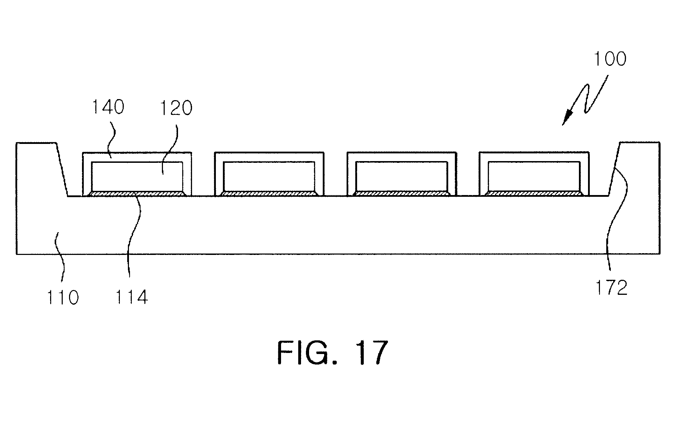

FIGS. 14 to 16 are sectional views showing different examples of the LED package according to an exemplary embodiment of the present invention. FIG. 17 is a schematic view showing a different example of the LED package according to an exemplary embodiment of the present invention.

In describing the examples of the LED package 100 according to an exemplary embodiment of the present invention, a description of the same or similar configurations as those described above will be omitted and a different configuration will be described.

First, with reference to FIG. 14, an LED package 100 is configured such that the plurality of LED chips 120 are mounted on the package substrate 110 having the cavity 172 and a transparent cover layer 180 covers the cavity 172.

Unlike the LED package illustrated in FIG. 10, in the present exemplary embodiment as shown in FIG. 14, the cavity 172 is formed on the package substrate 110 itself and the transparent cover layer 180, such as a lens, a glass layer, and the like, may be stacked on the package substrate 110 to cover the LED chips 120.

Also, in the present exemplary embodiment, as shown in FIG. 14, the light distribution layer 160 (in FIG. 10) and the light reflective layer 150 (in FIG. 10) are omitted, and the plurality of LED chips 120 having the horizontal structure illustrated in FIG. 5 can be mounted on the package substrate 110.

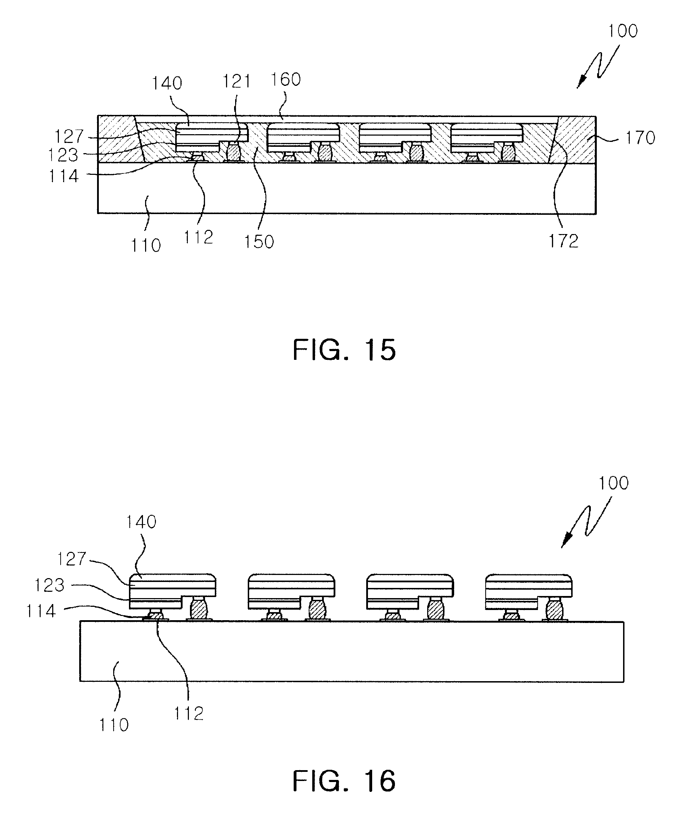

With reference to FIG. 15, an LED package 100 is configured such that the dam 170 is formed on the package substrate 110, the plurality of LED chips 120 are mounted in the cavity 172 demarcated by the dam 170, and the light reflective layer 150 and the light distribution layer 160 are formed.

Unlike the LED package 100 illustrated in FIG. 10, in the present exemplary embodiment, as shown in FIG. 15, the dam 170 made of a resin remains on the final product of the LED package 100.

In addition, in the present exemplary embodiment, as shown in FIG. 15, the plurality of LED chips 120 illustrated in FIG. 6 may be mounted on the package substrate 110 in the flip-chip manner.

With reference to FIG. 16, an LED package 100 is configured such that the plurality of LED chips 120 are mounted on the package substrate 110.

Unlike the LED package 100 illustrated in FIG. 10, in the present exemplary embodiment, as shown in FIG. 16, the light reflective layer 150 and the light distribution layer 16 may not be formed, and the plurality of LED chips 120 illustrated in FIG. 6 may be mounted on the package substrate 110 in the flip-chip manner.

With reference to FIG. 17, an LED package 100 is configured such that a plurality of LED chips 120 are mounted on the package substrate 110 having the cavity 172, and a plurality of wavelength conversion layers 140 are formed on the side surfaces of the LED chips 120 as well as on the upper surfaces of the LED chips 120.

In the present exemplary embodiment, as shown in FIG. 17, the wavelength conversion layers 140 can be extendedly formed even on the side surfaces of the respective LED chips 120 as well as on the upper surfaces of the LED chips 120. Accordingly, portions of the surfaces of the wavelength conversion layers 140 positioned at the sides of the LED chips 120 may be formed to be parallel to the sides of the LED chips 120 as shown in FIG. 17.

Namely, as shown in FIG. 17, the wavelength conversion layer 140 may be formed to have a uniform thickness so as to be parallel to the upper surface and the side surface of the LED chip 120. In this case, FIG. 17 is a schematic view of the LED package 100 according to the present exemplary embodiment in which the entirety of the surfaces of the wavelength conversion layer 140 is shown to be slightly exaggerated to have a surface parallel to the upper and side surfaces of the LED chip 120, but the portion of the wavelength conversion layer 140, which is actually formed by a process of manufacturing the LED package 100 (to be described), adjacent to the corners of the upper surface of the LED chip 120 and the portions of the side surface of the LED chip 120 may be formed as curved surfaces (148 in FIG. 10) like those in the foregoing exemplary embodiments.

According to the present exemplary embodiment, because the wavelength conversion layer 140 is formed on the side surface of the LED chip 120, the LED package 100 may be implemented to have an advantageous structure according to the structure of the applied LED chip 120. Namely, in the case of the LED chip 120 having the horizontal structure illustrated in FIG. 5, light can be partially emitted through the side of the LED chip 120, so the formation of the wavelength conversion layer 140 on the side of the LED chip 120 can be more advantageous.

Meanwhile, in the case of the LED packages 100 respectively illustrated in FIGS. 14 to 17, the LED chips 120 having the illustrated structures are not limitedly applied but the LED chips 120 illustrated in FIGS. 4 to 6 and an LED chip having any other structure may also be variably applicable to the LED package 100.

The configurations and functions of the LED packages 100 according to exemplary embodiments of the present invention have been described. Light sources for various lighting apparatuses, e.g., a streetlight, a camera flash, a guard lamp, a mood lamp, a vehicle head lamp, a lighting bulb for medical purposes, a backlight unit, a projector, and the like, can be implemented by using the LED package 100.

In detail, as discussed above, the LED package 100 according to the exemplary embodiments of the present invention can generate light having a uniform color temperature without causing color blurs, and the area of the entire light emission surface is reduced to have a low etendue. Thus, the LED package 100 according to the exemplary embodiments of the present invention can be actively utilized as a light source of a camera flash, a vehicle head lamp, a backlight unit, a projector, and the like.

A method for manufacturing an LED package 200 according to an exemplary embodiment of the present invention will now be described with reference to FIGS. 18 to 35.

In the present exemplary embodiment, an LED package 200, a package substrate 210, a circuit pattern 212, an adhesive layer 214, an LED chip 220, an electrode pad 221, a structure support layer 222, a light emission structure 223, a wire 230, a wavelength conversion layer 240, a flat surface 246, a curved surface 248, a light reflective layer 250, a light distribution layer 260, a dam 270, and a cavity 272 are the same as or similar to the LED package 100, the package substrate 110, the circuit pattern 112, the adhesive layer 114, the LED chip 120, the electrode pad 121, the structure support layer 122, the light emission structure 123, the wire 130, the wavelength conversion layer 140, the flat surface 146, the curved surface 148, the light reflective layer 150, the light distribution layer 160, the dam 170, and the cavity 172, so a detailed description of the structure will be omitted and a process for manufacturing the LED package 200 will be described.

FIG. 18 is a flow chart illustrating a process of a method for manufacturing the LED package 200 according to an exemplary embodiment of the present invention.

According to the present exemplary embodiment, as shown in FIG. 18, a method for manufacturing the LED package 200 includes a step S110 of mounting the LED chip on the package substrate 210, a step S130 of electrically connecting the package substrate 210 and the LED chip 220, a step S130 of forming the dam 270 on the package substrate 210 by using a dispenser 294, a step S140 of applying a mixture 249 to the upper surface of the LED chip 220 by using a dispenser 292 to form the wavelength conversion layer 240, a step S150 of forming the light reflective layer 250 on the package substrate 210, a step S160 of forming the light distribution layer 260, and a step S170 of removing the dam 270.

According to the present exemplary embodiment, because the wavelength conversion layer 240 is formed to have a uniform thickness on the upper surface of the LED chip 220, luminous efficiency of the LED package 200 can be improved, etendue can be reduced, and color blurs of light can be considerably reduced.

In addition, because the wavelength conversion layer 240 can be formed to have an appropriate thickness in consideration of the characteristics of the respective LED chips after the LED chips 220 are separated into unit LED chips, the variation in color temperature potentially generated among the respective LED packages 200 can be also effectively reduced.

First, the mixture 249 obtained by mixing the transparent resin (142 in FIG. 2), the phosphor (144 in FIG. 2), and a solvent to form the wavelength conversion layer 240 on the upper surface of the LED chip 220 will now be described.

In order to form a phosphor layer on the upper surface of the LED chip, a method of applying the mixture of the transparent resin and the phosphor to the LED chip and curing the resin may be used. However, with this method, it is difficult to form the phosphor layer having a uniform thickness because the applied mixture has a convex curved surface overall due to a surface tension of the transparent resin having high mobility before being cured.

Thus, in the present exemplary embodiment, the amount of phosphors (144 in FIG. 2) are relatively increased over the transparent resin (142 in FIG. 2) to increase the viscosity of the mixture 249 to reduce the mobility of the mixture 249 applied to the upper surface of the LED chip 220, and accordingly, the wavelength conversion layer 240 having the flat surface 246 can be formed. In this case, the weight ratio of the phosphors (144 in FIG. 2) to the transparent resin (142 in FIG. 2) is 2:1 or greater.

In this case, however, the increase in the amount of the phosphors (144 in FIG. 2) to increase the viscosity may cause a difficulty in performing a dispensing process, so a solvent may be added to the mixture 249 containing the transparent resin (142 in FIG. 2) and the phosphors (144 in FIG. 2) to temporarily lower the viscosity of the mixture 249 to increase the mobility when the mixture 249 is applied by using the dispenser 292.

In this manner, because the solvent is added to the mixture 249 containing the transparent resin (142 in FIG. 2) and the phosphors (144 in FIG. 2) to temporarily provide mobility to the mixture 249, the wavelength conversion layer 240 having a uniform thickness can be effectively formed on the upper surface of the LED chip 220.

The solvent is a material for providing a temporary mobility to the mixture 249. For example, the solvent may be a volatile material which is evaporated after the mixture 249 is applied to the upper surface of the LED chip 220, and a material of an organic solvent group such as polymer, monomer, alcohol, acetone, or the like, having a relatively low molecular weight can be used as the solvent.

Also, the solvent is a material for providing a certain level of mobility to the mixture 249 having a reduced mobility due to the increased amount of phosphors (144 in FIG. 2), so a large amount of solvent is not required and, for example, the solvent may be mixed at a level of one-tenth of the phosphors (144 in FIG. 2) based on the weight ratio thereof.

In addition, the mixture 249 may further contain transparent fine particles made of a material such as SiO₂, TiO₂, and Al₂O₃ in order to regulate the color temperature, and the transparent fine particles may be combined to have a weight ratio of 1/2 or less with respect to the phosphors (144 in FIG. 2).

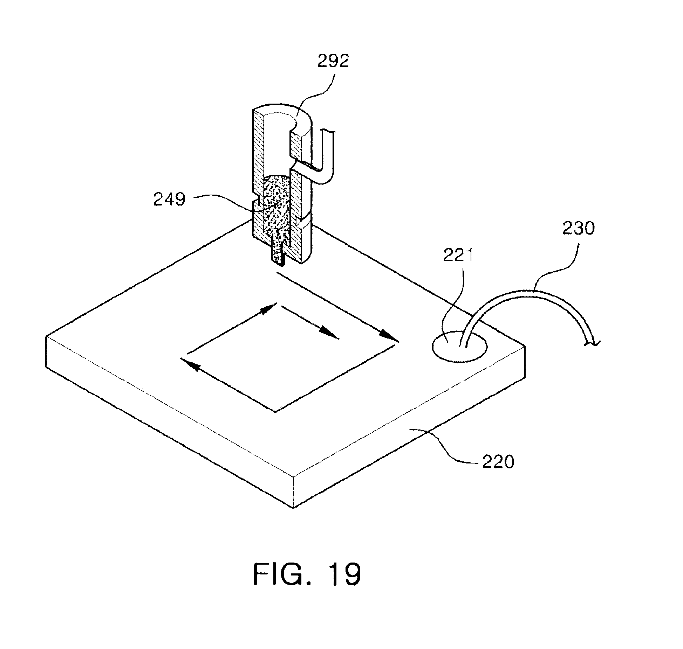

The process of forming the wavelength conversion layer 240 in the method for manufacturing the LED package 200 by using the mixture 249 including the transparent resin (142 in FIG. 2), the phosphors (144 in FIG. 2), and the solvent according to an exemplary embodiment of the present invention will now be described with reference to FIGS. 19 to 21.

FIGS. 19 to 21 are views showing a process of forming a wavelength conversion layer in the method for manufacturing an LED package according to an exemplary embodiment of the present invention.

First, as shown in FIG. 19, the mixture 249 including the transparent resin (142 in FIG. 2), the phosphors (144 in FIG. 2), and the solvent is applied to the upper surface of the LED chip 220 by using the dispensers 292 and 294.

The LED chip 220 is mounted on the package substrate 210 and, after the LED chip 220 and the package substrate 210 are wire-bonded, the mixture 249 may be dispensed, and accordingly, the electrode 221 of the package 200 and a portion of the wire 230 may be buried by the mixture 249.

Namely, the mixture 249 is disposed to cover even the electrode pad 221 as well as the surface of the LED chip 220 for emitting light, and in this process, even a portion of the wire 230 may be covered by the wavelength conversion layer. Meanwhile, in the present exemplary embodiment, the dispensing may refer to continuously applying of the phosphor mixture, with pressure applied thereto by a pump, through a needle (namely, in most cases, the state in which the phosphor mixture is applied from the dispenser to the upper surface of the chip is maintained), which is different from a process such as spray coating in which a material is particulated to be sprayed in the air, or the like.

As stated above, the mixture 249, which initially has a reduced mobility due to the increase in the amount of the phosphors (144 in FIG. 2) but currently has an improved mobility temporarily according to the addition of the solvent in the dispensing process, can be smoothly discharged from the dispenser 292.

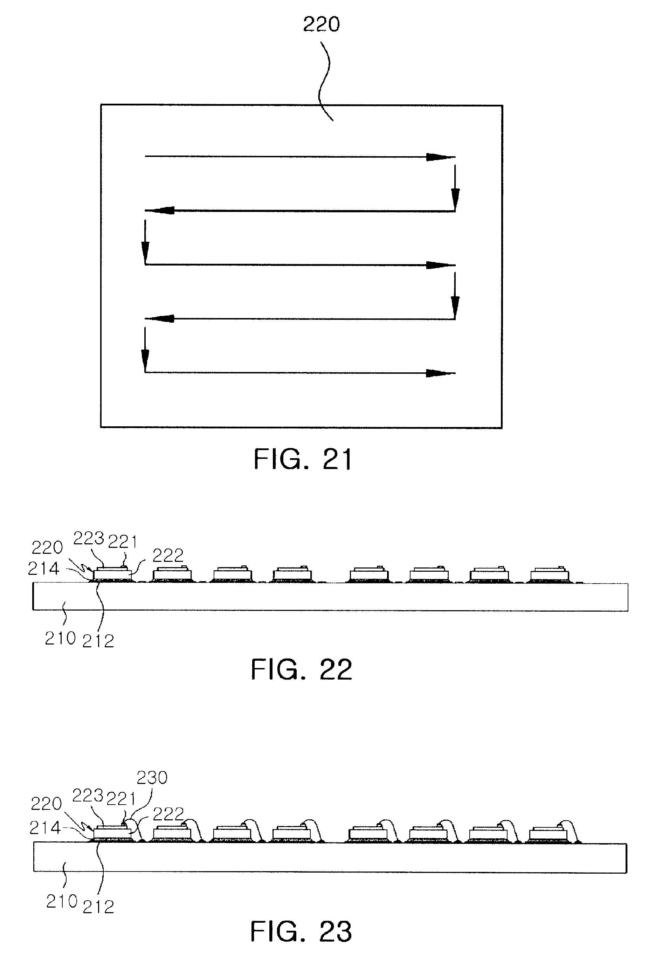

In this case, as shown in FIG. 19, the mixture 249 can be uniformly applied by moving the dispenser 292 in a spiral manner, or as shown in FIG. 21, the mixture 249 can be uniformly applied by moving the dispenser 292 in a zigzag manner.

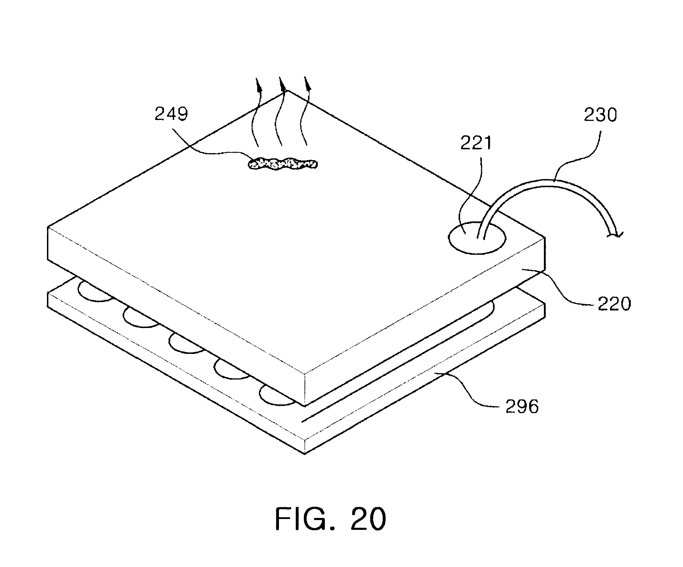

Thereafter, as shown in FIG. 20, the mixture 249 is heated by a heating device 296 to allow the solvent of the mixture 249 to be evaporated.

As mentioned above, the solvent may be made of a volatile material, so it may be evaporated to be removed without the use of the heating device 296. Accordingly, only the transparent resin (142 in FIG. 2) and the phosphors (144 in FIG. 2)) remain on the upper surface of the LED chip 220 to form the wavelength conversion layer 240 made up of them.

In this case, in order to prevent the wavelength conversion layer 240 from being deformed due to the mobility of the mixture 249 potentially caused by a delay in the evaporation of the solvent, the mixture 249 including the solvent may be heated by the heating device 296. For example, the LED chip 220 may be heated within a temperature range from 50 degrees Celsius to 170 degrees Celsius, whereby the mixture 249 can be heated and the solvent in the mixture 249 can be more effectively removed.

The respective processes of the method for manufacturing the LED package according to the present invention will now be described with reference to FIGS. 18 to 35.

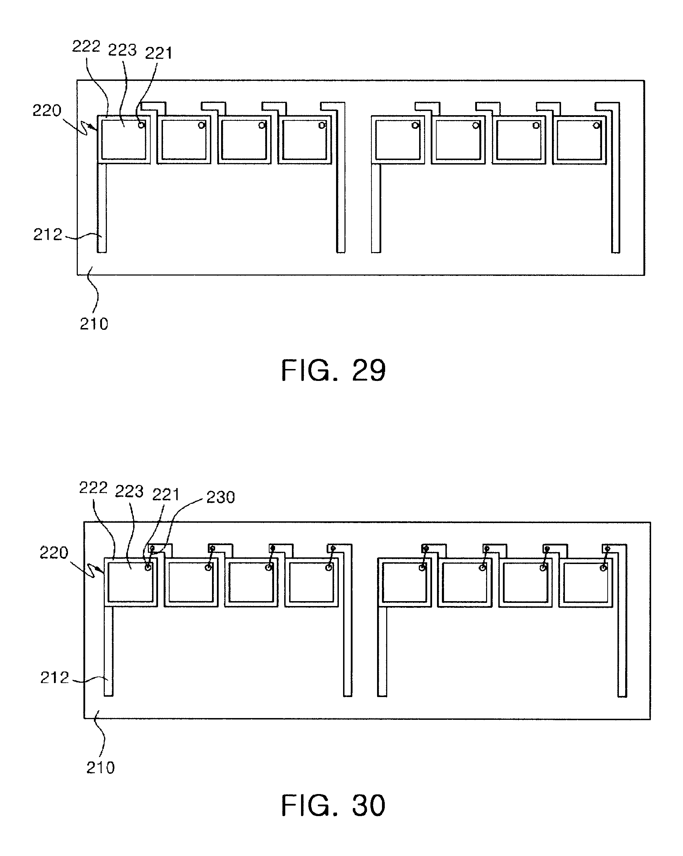

FIGS. 22 to 28 are sectional views showing the respective processes of the method for manufacturing an LED package according to an exemplary embodiment of the present invention. FIGS. 29 to 35 are plan views showing the respective processes of the method for manufacturing an LED package according to another exemplary embodiment of the present invention.

First, as shown in FIGS. 22 to 29, a plurality of LED chips 220 are mounted on the package substrate 210 (step S110). Namely, the plurality of LED chips 220 are mounted on the package substrate 210 with the circuit patterns 212 formed on one surface thereof, and in this case, the LED chips 220 may be physically bonded and electrically connected to the circuit patterns 212 of the package substrate 210 by the adhesive layers 214.

In this case, the LED chips 220 may be electrically connected in series to the circuit patterns 212 formed on the package substrate 210. However, the present invention is not limited thereto and the LED chips 220 may be electrically connected in parallel to the circuit patterns 212 or may be electrically connected both in series and in parallel to the circuit patterns 212.

In the present exemplary embodiment, as shown in FIGS. 22 and 29, a total of eight LED chips 220 are mounted on the package substrate 210 to form two unit packages, which are then separated later through a dicing process, but the present invention is not limited thereto and the number of the mounted LED chips 220 and the number of diced unit packages may be variably modified as necessary.

As shown in FIGS. 23 and 30, electrode pads 221 are electrically connected to the package substrate 210 by using wires 230 (step S120). In the present exemplary embodiment, the LED chip 220 having the vertical structure illustrated in FIG. 4 is used as an example, and because the electrode pad 221 is formed on the upper surface of the LED chip 220, the electrode pad 221 may be electrically connected to the circuit pattern 212 of the package substrate 210 by the wire 230.

When the LED chip 120 illustrated in FIG. 6 is used in the present exemplary embodiment, because the electrode pad 121 is not formed on the upper surface of the LED chip 220, this process can be omitted.

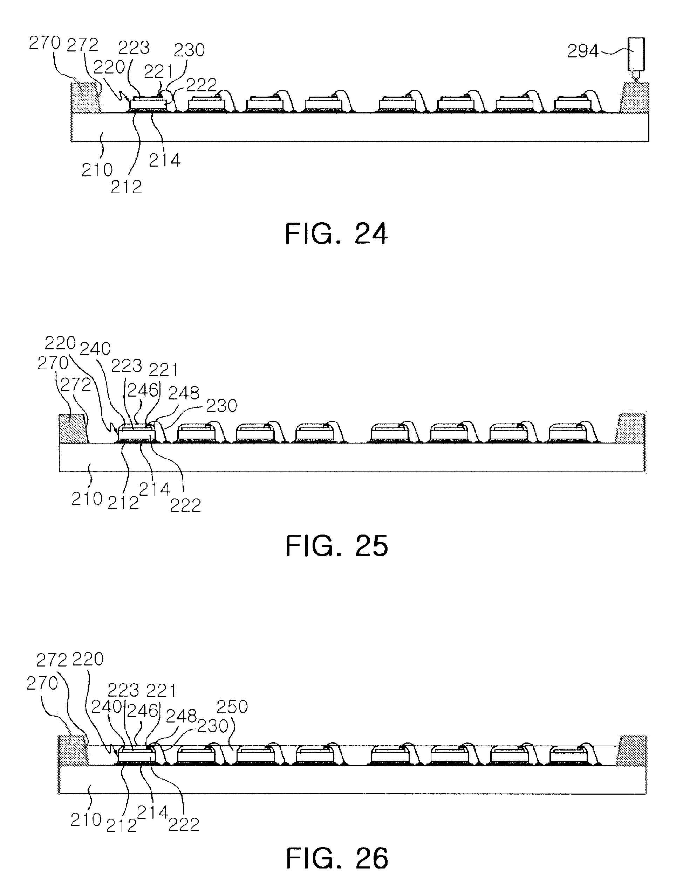

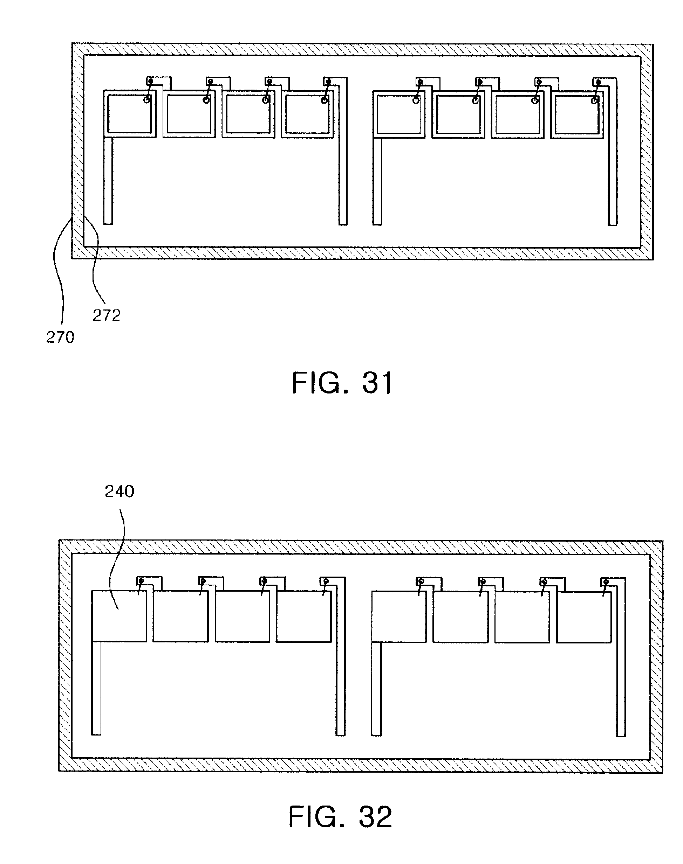

Thereafter, as shown in FIGS. 24 and 31, the dam 270 is formed on the package substrate 210 by using the dispenser 294 to demarcate the cavity 272 accommodating the LED chips 220, the light reflective layers 250, and the light distribution layers 260 therein (step S130). Namely, in this process, the dam 270 is formed by applying a resin material along the edges of the package substrate 210 by using the dispenser 294. The formation of the dam 270 constitutes the cavity 272 for accommodating the LED chips 220, the light reflective layers 250, and the light distribution layers 260 therein.

In this case, the resin material used for forming the dam 270 may be a buffering material. Thus, although the package substrate 110, which is made of a ceramic material, is expanded or contracted according to heating and cooling operations in the manufacturing process, because the dam 170 can be deformed to correspond to the degree of expansion and contraction, a phenomenon in which the package substrate 210 is bent, or the like, can be effectively prevented and AlN having excellent thermal resistance may be used as a material of the package substrate 210.

When the cavity 172 is formed on the package substrate 110 like the LED package 100 illustrated in FIG. 7 or 8, or when the package substrate 110 includes the first and second substrates 116 and 118, this process may be omitted.

Thereafter, as shown in FIGS. 25 and 32, the mixture 249 including the transparent resin (142 in FIG. 2), the phosphors (144 in FIG. 2), and the solvent is applied to the upper surface of the respective LED chips 220 by using the dispenser 292 to form the wavelength conversion layer 240 (step S1540).

As described above with reference to FIGS. 19 to 21, the wavelength conversion layer 240 can be formed by dispensing the mixture 249 including the transparent resin (142 in FIG. 2), the phosphors (144 in FIG. 2), and the solvent to each of the upper surfaces of the LED chips 220.

Namely, as discussed above, the amount of the phosphors (144 in FIG. 2) may be increased to be more than double based on, for example, the weight ratio, over the transparent resin (142 in FIG. 2) to reduce the mobility of the mixture of the transparent resin and the phosphors to thus form the wavelength conversion layer 240 having the flat surface 246 formed at the other portion than the portions adjacent to the corners of the upper surface of the LED chip 220. In this case, however, the increase in the viscosity of the mixture 249 due to the phosphors (144 in FIG. 2) may prevent a smooth application of the mixture 249, so the solvent is added to the mixture 249 for a smooth dispensing operation to thus provide a temporary mobility to the mixture 249 in the dispensing process. Accordingly, the mixtures 249 can be effectively applied to the upper surface of the LED chip 220, while the configuration, the thickness, or the like, of the wavelength conversion layer 240 can be precisely adjusted.

As described above, the solvent may be made of a volatile material to provide a temporary mobility, and the amount of the solvent may be approximately one-tenth the phosphors (144 in FIG. 2) based on the weight ratio.

Meanwhile, in the case of the LED package 100 illustrated in FIG. 17, the mixture 249 is applied even to the side surface of the LED chip 120, as well as to the upper surface of the LED chip 120, to form the wavelength conversion layer 140 extending from the upper surface of the LED chip 120 to the side surface of the LED chip 120.

Also, in this case, the solvent may be evaporated to be removed while the mixture 249 is being applied to the upper surface and the side surface of the LED chip 120, and accordingly, the surface of the wavelength conversion layer 140 can have the flat surface 246 parallel to the upper surface and side surface of the LED chip 120.

Subsequently, as shown In FIGS. 26 to 33, the light reflective layer 250 is formed on the package substrate 210 to surround the sides of the LED chips 220 (step S150). For example, the light reflective layer 250 may be formed by charging the areas around the LED chips 220 with a material including a reflection material (or a reflector), such as TiO₂, or the like, through a dispending or molding operation.

In this case, because the dam 270 formed on the package substrate 210 demarcates the cavity 272 for the formation of the light reflective layer 250, according to the foregoing process, the light reflective layer 250 can be more easily formed.

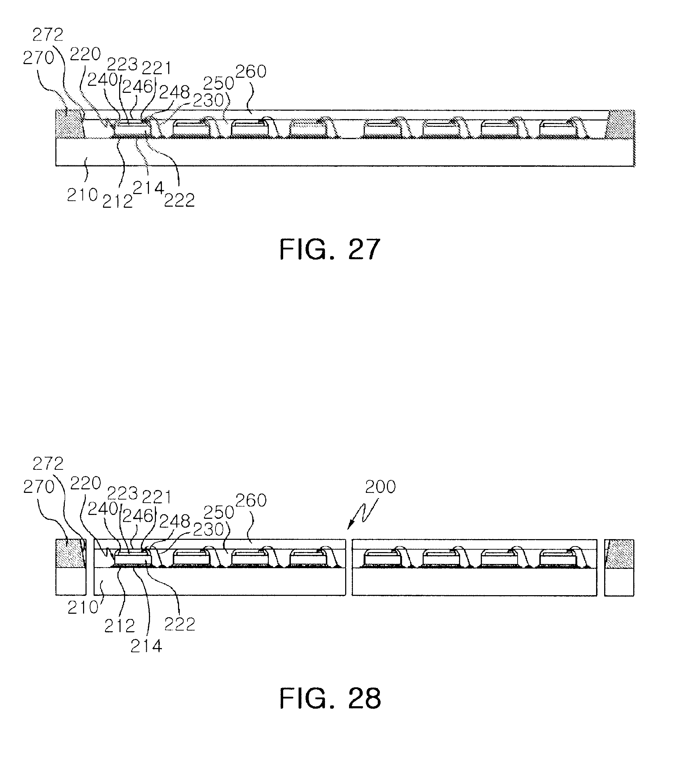

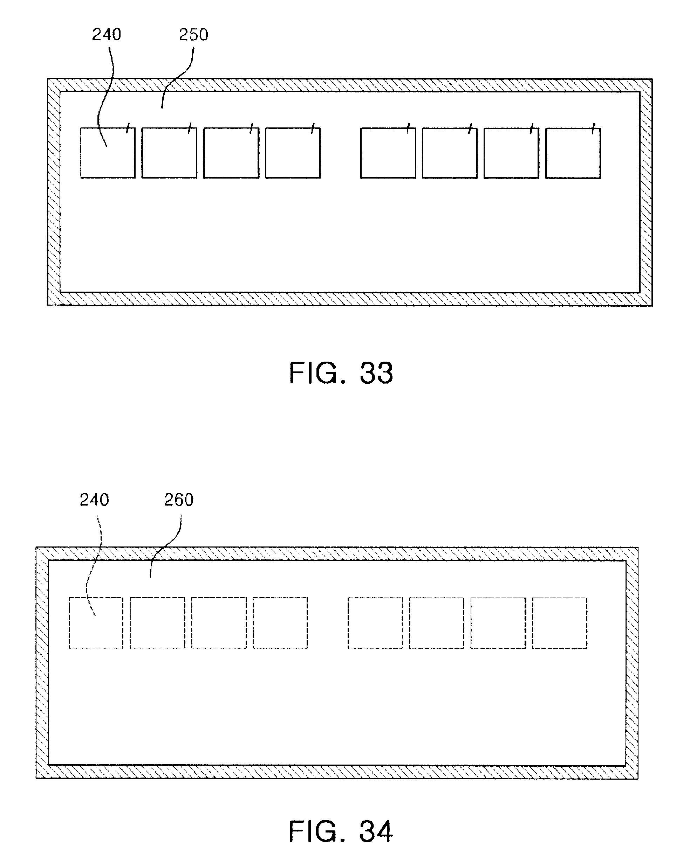

Then, as shown in FIGS. 27 and 34, the light distribution layer 260 covering the wavelength conversion layer 240 and the light reflective layer 250 is formed (step S160). For example, the light distribution layer 260 may be formed by applying a material including a dispersing agent, such as SiO₂, or the like, to the light reflective layer 250 and the wavelength conversion layer 240 through a dispensing operation.

Like the light reflective layer 250, the light distribution layer 260 can be also easily formed by virtue of the foregoing dam 270.

Meanwhile, in case of the LED package 100 illustrated in FIG. 14, the light reflective layer 150 and the light distribution layer 160 are omitted and the transparent cover layer 180 is formed on the LED chip 120. Thus, in the case of the LED package 100 illustrated in FIG. 14, the process of forming the light reflective layer 150 and the process of forming the light distribution layer 160 are omitted, while the process of forming the transparent cover layer 180 on the LED chip must be additionally performed.

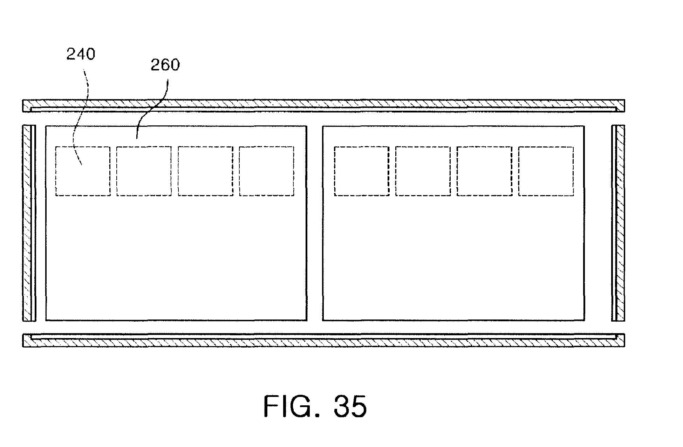

Thereafter, as shown in FIGS. 28 and 35, the dam 270 and the edges of the package substrate 210 where the dam 270 are formed are removed (step S170). Namely, after the light distribution layer 260 is formed, the package substrate 210 is diced into unit LED packages 200, and the dam 270 used for the formation of the light reflective layer 250 and the light distribution layer 260 and the edges of the package substrate 210 where the dam 270 is formed may be removed.

As described above, in the present exemplary embodiment, the process of manufacturing the LED package 200 in which the plurality of LED chips 220 are mounted on the package substrate 210 and separated through a dicing process is taken as an example. However, as shown in FIG. 15, in case in which the LED package with the dam 170 remaining in the final product is manufactured, the process of removing the dam 270 may be omitted.

As set forth above, according to exemplary embodiments of the invention, because the overall area of a light emission surface of the LED package is reduced, a luminous efficiency of the LED package can be improved. Also, because light having a uniform color temperature is emitted from a light emission surface at an upper side of the LED chip, light color blurs can be reduced. In addition, a color temperature variation potentially generated among products can be also effectively reduced.

While the present invention has been shown and described in connection with the exemplary embodiments, it will be apparent to those skilled in the art that modifications and variations can be made without departing from the spirit and scope of the invention as defined by the appended claims.

## Claims

1. A light emitting diode (LED) package comprising:
a package substrate;
an LED chip mounted on the package substrate; and
a wavelength conversion layer formed to cover at least a portion of an upper surface of the LED chip when a surface formed by the LED chip when viewed from above is defined as the upper surface of the LED chip,
wherein the wavelength conversion layer is formed so as
not to exceed the area of the upper surface of the LED chip and includes a flat surface parallel to the upper surface of the LED chip and curved surfaces connecting the corners of the upper surface of the LED chip.

2. The package of claim 1, further comprising:
a light reflective layer formed on the package substrate to surround the sides of the LED chip.

3. The package of claim 2, wherein the light reflective layer is made of a material including TiO₂.

4. The package of claim 2, further comprising:
a light distribution layer covering the wavelength conversion layer and the light reflective layer.

5. The package of claim 4, wherein the light distribution layer is made of a material including SiO₂.

6. The package of claim 4, further comprising:
a dam formed on the package substrate to demarcate a cavity for accommodating the LED chip, the light reflective layer, and the light distribution layer therein.

7. The package of claim 6, wherein the dam is made of a material including a resin.

8. The package of claim 1, further comprising:
a transparent cover layer covering the LED chip.

9. The package of claim 1, wherein the package substrate is made of a material including a ceramic.

10. The package of claim 1, wherein the wavelength conversion layer is made of a material including a transparent resin and phosphors.

11. The package of claim 10, wherein the weight ratio of the phosphors to the transparent material is 2:1 or greater.

12. The package of claim 2, wherein the LED chip comprises:
a structure support layer made of a conductive material; and
a light emission structure formed on one surface of the structure support layer and including a p type semiconductor layer, an active layer, and an n type semiconductor layer.

13. The package of claim 12, wherein the light emission structure is formed on a portion of one surface of the structure support layer, and the upper surface of the LED chip comprises one surface of the light emission structure and the other remaining area of one surface of the structure support layer in which the light emission structure is not formed.

14. The package of claim 1, wherein the LED chip comprises:
a growth substrate; and
a light emission structure formed on one surface of the growth substrate and including an n type semiconductor layer, an active layer, and a p type semiconductor layer,
wherein the active layer and the p type semiconductor layer are formed on a portion of one surface of the n type semiconductor layer.

15. The package of claim 2, wherein the upper surface of the LED chip comprises one surface of the p type semiconductor layer and the other remaining area of one surface of the n type semiconductor layer in which the active layer and the p type semiconductor layer are not formed.

16. The package of claim 14, wherein the upper surface of the LED chip is the other surface of the growth substrate.

17. The package of claim 1, further comprising:
an electrode pad formed on the upper surface of the LED chip,
wherein the wavelength conversion layer is formed to cover the electrode pad.

18. The package of claim 17, further comprising:
a wire electrically connecting the electrode pad to the package substrate.

19. The package of claim 1, wherein the wavelength conversion layer extends to a side surface of the LED chip.

20. The package of claim 1, wherein a plurality of LED chips and a plurality of wavelength conversion layers are formed, and the plurality of wavelength conversion layers are formed on upper surfaces of the plurality of LED chips, respectively.
